# EUROPEAN PATENT APPLICATION

(11) **EP 1 772 532 A1**
(43) Date of publication of application: **11.04.2007**
(21) Application number: 06255154.4
(22) Date of filing: 05.10.2006
(51) Int. Cl.: C23C 14/06, C23C 14/02, C23C 14/32, F16C 33/12

(54) **Metal composite diamond-like carbon (DLC) film. Method and apparatus for forming the same and slide member making use of it.**

(30) Priority: 06.10.2005 JP 2005293924
(71) Applicant: TOYOTA JIDOSHA KABUSHIKI KAISHA, Toyota-shi, Aichi-ken 471-8571 (JP)
(72) Inventor: Shimoda, Kenji, Aichi 471-8571 (JP); Kobayashi, Kinya, Aichi 471-8571 (JP); Nishimura, Etsuko, Aichi 471-8571 (JP)
(74) Representative: Duckworth, Timothy John

(57) **Abstract**

A DLC film that has a low friction coefficient and that is superior in adhesion and wear resistance, and a method for forming the film are provided. A slide member having a protective film that has a low friction coefficient and that is superior in wear resistance and adhesion, and a method for forming the member are provided. Without using a solid carbon target, a metal composite diamond-like carbon (DLC) film is formed on a base material by introducing hydrocarbon gas as a metal target alone is sublimated by arc discharge and ionizing the metal and the hydrocarbon.

## Description

### BACKGROUND OF THE INVENTION

### Field of the Invention

The present invention relates to a metal composite diamond-like carbon (DLC) film and a method for forming the same, and it also relates to a slide member having a metal composite diamond-like carbon (DLC) film on a surface thereof.

### Background Art

Since a diamond-like carbon (to be hereafter referred to as "DLC") is superior in hardness, wear resistance, solid lubricity, thermal conductivity, and chemical stability, and has the property of a low friction coefficient, it is very effective in modifying a surface of various types of members. Thus, the DLC has been utilized as a surface layer of various types of members such as slide members, wear-resistant machine parts, and cutting tools.

JP Patent Publication (Kokai) No. 2003-247060 A discloses a method for forming an amorphous carbon film comprising the additive metal, carbon, and hydrogen on a base material by introducing hydrocarbon gas and inert gas while solid carbon targets and a metal target are sputtered. It discloses that wear resistance and adhesion can be obtained, and friction coefficient can be reduced in accordance with the method.

Meanwhile, arc-type ion plating (hereafter "AIP) is a process often used for the hard-coating (TiN, CrN, TiAIN, or the like) of machine tools. Various methods for making DLC films using this process have been proposed.

JP Patent Publication (Kokai) No. 2003-82458 A discloses a method for easily forming an amorphous carbon film that has a low friction coefficient and that is superior in adhesion to a base material and in surface smoothness. In accordance with the method, at lease one kind of metal selected from the group consisting of IVa, Va, VIa, and IIIb groups of the periodic table is set in a cathode arc-type evaporation source as a raw material, and as the metal is caused to evaporate, metal ions are emitted to the base material to which a bias is applied in a vacuum chamber. Next, carbon atoms evaporated from an evaporation source in which a solid carbon is set are emitted to the base material in the vacuum chamber, thereby depositing an amorphous carbon film on the base material.

### SUMMARY OF THE INVENTION

With regard to slide members such as automobile parts, in order to improve fuel efficiency due to friction reduction, further reduction of the friction coefficient is necessary. However, in accordance with the conventional technology disclosed in Patent Document 1 or the like, the friction coefficient is approximately 0.18 in a dry environment, which is not sufficiently low. Further, a processing cost for the coating through evaporation is high, as a rule. Particularly, a sputtering process involving a carbon target (including the conventional technologies disclosed in the above Patent Documents) is even more costly, since the carbon sputtering rate is very low and the film formation rate is slow.

The causes of such problems are as follows:
(1) When a solid carbon target is used, projections are easily formed on the target surface and they attach to a work, causing a surface of the work to be rough. Further, when a solid carbon target is used as a source for supplying carbons, the surface roughness tends to increase, since constituent particles of the surface are larger, compared with those when carbons are supplied via hydrocarbon gas. Thus, it can be presumed that a DLC film formed by a conventional technology has a high friction coefficient.
(2) In the case of sputtering used in the conventional technologies, it is important to decrease cycle time for cost reduction, by using more targets and increasing the film formation rate. However, if a plurality of types of targets are used, cycle time is caused to be increased thereby. Further, it is considered that the solid carbon target disclosed in the conventional technologies is costly since it has the lowest sputtering rate among the materials, and thus coating for obtaining a necessary film thickness takes time.

With regard to the arc-type ion plating, due to high energy density plasma formed by arc discharge, the rate at which evaporated atoms are ionized is high, and a film with high density and adhesion can be obtained. Thus, it has been applied to machine tools and the like. Graphite has been used as a material for forming a DLC film by AIP. In such cases, a hard DLC film can be obtained since hydrogen is not contained in the film and due to its high density. It is noted, however, that the film has a conflicting phenomenon that the toughness of the film is low because of its high hardness. For example, cracking or peeling of the film easily occurs upon abrasive wear, such as being scratched by abrasive grains during sliding. With regard to the bonding state of carbons, the ratio of SP3 (diamond structure) is high while that of SP2 (graphite structure) attributable to low friction phenomenon is low, and therefore the friction coefficient is approximately µ= 0.1 to 0.2, which is not very low.

Thus, the conventional DLC film formed by using the arc-type ion plating process is insufficient to be applied to an automobile slide member, so as to improve fuel efficiency and obtain durability by reducing friction.

It is an object of the invention to provide a DLC film, and a method and apparatus for forming the film, wherein the DLC film has a lower friction coefficient, higher adhesion, higher wear resistance, higher film formation rate, and a shorter cycle time, compared with those of a conventional DLC. Further, it is another object of the invention to provide a slide member having a protective film that has a low friction coefficient and that is superior in wear resistance and adhesion, and to provide a method for making the member.

The inventors have found that a metal composite diamond-like carbon (DLC) film obtained by a certain arc-type ion plating (AIP) process, instead of a sputtering process, is superior in wear resistance and adhesion and has a low friction coefficient (µ). Thus, the present invention has been made.

Namely, in a first aspect, the invention relates to a metal composite diamond-like carbon (DLC) film, wherein the film is formed on a base material by introducing hydrocarbon gas as a metal target alone is sublimated by arc discharge, without using a solid carbon target, and by ionizing the metal and the hydrocarbon.

A variety of metal elements that are ion-plated through sublimation by arc discharge can be used. As such metal elements, those having superior ability in oxide and carbide formation are used, of which at least one selected from the group consisting of the IV-A, V-A, VI-A, and III-B group elements and Si is preferable. More specifically, at least one selected from the group consisting of Ta, Ti, Cr, Al, Mg, W, V, Nb, and Mo is preferable, of which Ta, Ti, and Cr are particularly preferable.

In a metal composite diamond-like carbon (DLC) film of the invention, it is preferable that the atomic ratio of carbon/metal elements in the diamond-like carbon (DLC) film formed on the base material is 10 to 40.

When Ti is used as a metal element, it is preferable that the C/Ti ratio in the diamond-like carbon (DLC) film is 10 to 25, and that the O/Ti ratio in the diamond-like carbon (DLC) film is 0.4 to 1.0.

When Cr is used as a metal element, it is preferable that the C/Cr ratio in the diamond-like carbon (DLC) film is 10 to 40.

The friction coefficient of the metal composite diamond-like carbon (DLC) film of the invention is low. For example, the friction coefficient can be made 0.1 or below, and it can be further reduced to 0.05 or below.

In a second aspect, the invention relates to a method for forming the metal composite diamond-like carbon (DLC) film, wherein the metal composite diamond-like carbon (DLC) film is formed on a base material by disposing a metal target alone, without using a solid carbon target, as a cathode in a vacuum chamber, ionizing the metal and the hydrocarbon as the metal target is sublimated by arc discharge, and introducing hydrocarbon gas into the vacuum chamber. The invention differs from the conventional technologies in that the metal target alone is ion-plated (arc-type ion plating (AIP) process) by arc discharge, while, in a conventional sputtering, a solid carbon target as a carbon evaporation source is used in combination with a metal target as a metal evaporation source.

Preferably, the hydrocarbon gas used in the method for forming a metal composite diamond-like carbon (DLC) film of the invention is at least one of chain hydrocarbon compounds selected from the group consisting of alkane, alkene, and alkyne compounds. Among these, at least one selected from the group consisting of methane, ethylene, and acetylene is preferable.

In the method for forming the metal composite diamond-like carbon (DLC) film of the invention, after forming the metal composite diamond-like carbon (DLC) film, it is preferable to remove generated macro-particles (droplets) as a post-treatment. At least one of the methods selected from the group consisting of water jet, sand paper, paper lap, and aero lap is preferable as the method for removing macro-particles (droplets).

In a third aspect, the invention relates to an apparatus for forming the diamond-like carbon (DLC) film used for the method for forming the metal composite diamond-like carbon (DLC) film. The apparatus comprises an arc power supply, a bias power supply for applying a negative bias to a base material in a vacuum chamber in which the diamond-like carbon (DLC) film is formed, and an opening for introducing hydrocarbon and inert gas, and it is structured such that the arc power supply is provided with a metal target alone. The diamond-like carbon (DLC) film is formed on the base material by ionizing the metal and the hydrocarbon as the metal target alone is sublimated by arc discharge, without using a solid carbon target, under hydrocarbon and inert gas atmosphere.

As described above, preferably, the metal element used as the metal target is at least one selected from the group consisting of the IV-A, V-A, VI-A, and III-B group elements and Si.

In a fourth aspect, the invention relates to a slide member having the metal composite diamond-like carbon (DLC) film, and it includes the following (1) to (3):
(1) A slide member comprising a base material and a protective film formed on a surface of the base material, wherein the protective film comprises the metal composite diamond-like carbon (DLC) film.
(2) A slide member comprising a base material and a protective film formed on a surface of the base material, wherein the protective film comprises (a) a hard layer comprising metal nitride or metal carbonitride, (b) a metal-carbon composition graded layer formed on the hard layer, and (c) the metal composite diamond-like carbon (DLC) film formed on the metal-carbon composition graded layer. In this way, adhesion between the low friction DLC film and the base material can be ensured.
(3) A slide member comprising a base material and a protective film formed on a surface of the base material, wherein the protective film comprises (a) a hard layer comprising metal nitride or metal carbonitride, (b) a metal-carbon composition graded layer formed on the hard layer, and (d) an alternately laminated layer of the metal composite diamond-like carbon (DLC) film formed on the metal-carbon composition graded layer and a metal-carbon hard layer obtained by reducing the amount of hydrocarbon gas added. In this way, the wear resistance of a low friction DLC film having high adhesion can be ensured.

The invention includes cases where (a) the hard layer comprising metal nitride or metal carbonitride comprises two or more layers.

The friction coefficient of the slide member comprising the metal composite diamond-like carbon (DLC) film of the invention is low. For example, the invention includes a slide member of which friction coefficient is 0.1 or below, and particularly it includes a slide member of which friction coefficient is 0.05 or below.

The film hardness of the slide member comprising the metal composite diamond-like carbon (DLC) film of the invention is high. It is preferable that the dynamic hardness of the film hardness is 1000 to 3000 when the measuring load is 5 mN.

The metal-carbon composition graded layer assures adhesion by gradually softening the DLC film and reducing internal stress. Examples of the method for continuously changing the hardness of the DLC film are as follows:
(1) the bias voltage during film formation is controlled;
(2) the kind and amount of hydrocarbon gas added during film formation are adjusted; and
(3) the amount of nitrogen gas added during film formation is controlled.

In accordance with the invention, a metal composite diamond-like carbon (DLC) film having a low friction coefficient can be obtained. Further, by incorporating the metal composite diamond-like carbon (DLC) film having a low friction coefficient as a protective layer or as part thereof, a slide member that has a low friction coefficient and that is superior in wear resistance and adhesion can be obtained.

### BRIEF DESCRIPTION OF THE DRAWINGS

Fig. 1 schematically shows a diagram of an arc ion plating (AIP) apparatus used for making a metal composite diamond-like carbon (DLC) film of the invention.
Fig. 2 schematically shows a cross-sectional view of a slide member that ensures adhesion and wear resistance.
Fig. 3 shows friction coefficients of films formed by changing the volume of acetylene flow and a bias voltage.
Fig. 4 shows a schematic diagram of a ball-on-disk test.
Fig. 5 shows the results in which the relationship between the carbon-to-metal ratio of the film and the friction coefficient is organized.
Fig. 6 shows the relationship between the hardness of the film and the depth of wear.
Fig. 7 shows the results of an analysis, using an atomic force microscope (AFM), on a film surface form of a Ti composite DLC film formed by a sputtering process and that of a Ti composite DLC film formed by an AIP process of the present invention.
Fig. 8(a) shows a cross-sectional view of a slide member including a DLC film having the graded layer of the invention, and Fig. 8(b) shows an example of coating conditions when forming the film.
Fig. 9 shows comparison of hardness characteristics between a member of which hard layer was formed by the AIP process and a member of which hard layer was formed by a sputtering process.

### DESCRIPTION OF PREFERRED EMBODIMENTS OF THE INVENTION

Embodiments of the present invention will be described with reference to the drawings in the following.

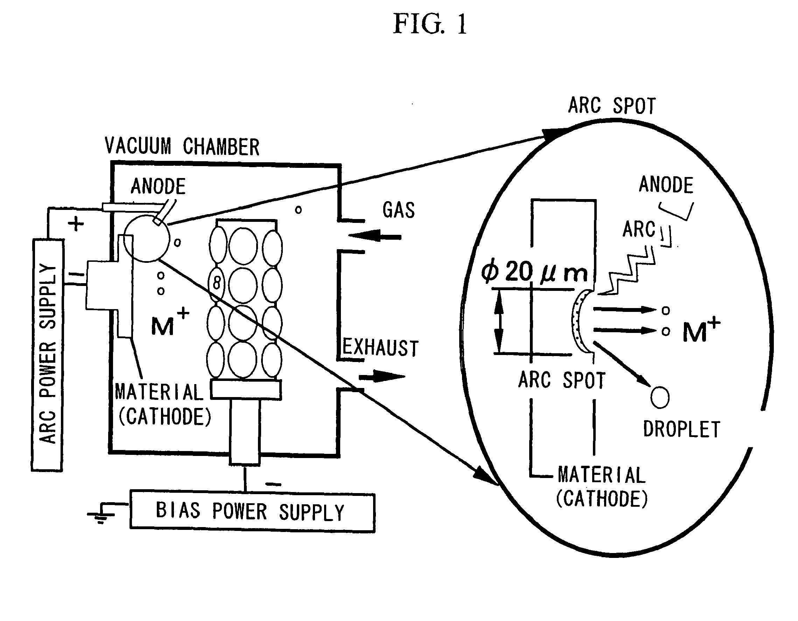

Fig. 1 schematically shows a diagram of an arc ion plating (AIP) apparatus used for making a metal composite diamond-like carbon (DLC) film of the invention. A plurality of metal targets are disposed in a vacuum chamber (vacuum container) exhausted by a vacuum pump, and a work, which is a base material on which a film is formed, is disposed on a rotary table in the center. A discharge gas, such as nitrogen or argon, is introduced into the vacuum container via a nozzle, and hydrocarbon gas, which is a process gas other than the discharge gas, is also introduced via the nozzle. The metal targets act as a cathode of an arc power supply and the metals are sublimated and ionized by arc discharge with the anode. In order to form a metal layer on the work, metal targets such as Cr, Ti, and Ta are disposed as ion sources. For such metals, materials with which oxides or carbides are easily formed are selected. Examples include W, V, Nb, and Mo, aside from Cr, Ti, and Ta. In the present invention, a carbon target is not used as an ion source.

As shown in Fig. 1, a material (conductive metal or carbon, for example) is used as a cathode, and an arc discharge is generated with the anode. The material is sublimated by this energy and is ionized by high energy density plasma, and ions are drawn to the work to be deposited by applying a negative bias voltage to an object to be processed. When a typical TiN film is formed, Ti is used as a material, nitrogen is used as a gas to be introduced, and they are caused to bind together on the surface of the work. In a conventional technology, when using the method for forming a DLC film, carbon (graphite) is used as a material, and thus it has been proposed to devise apparatus structures or methods to prevent adhesion of droplets. In any event, as the case now stands, advantages of the AIP process are sacrificed: the efficiency of film formation significantly deteriorates, for example. While the inventors used carbon, it did not seem practicable since the material surface was caused to be significantly rough due to unstable discharge. Thus, in the present invention, a DLC film is formed without using a carbon material.

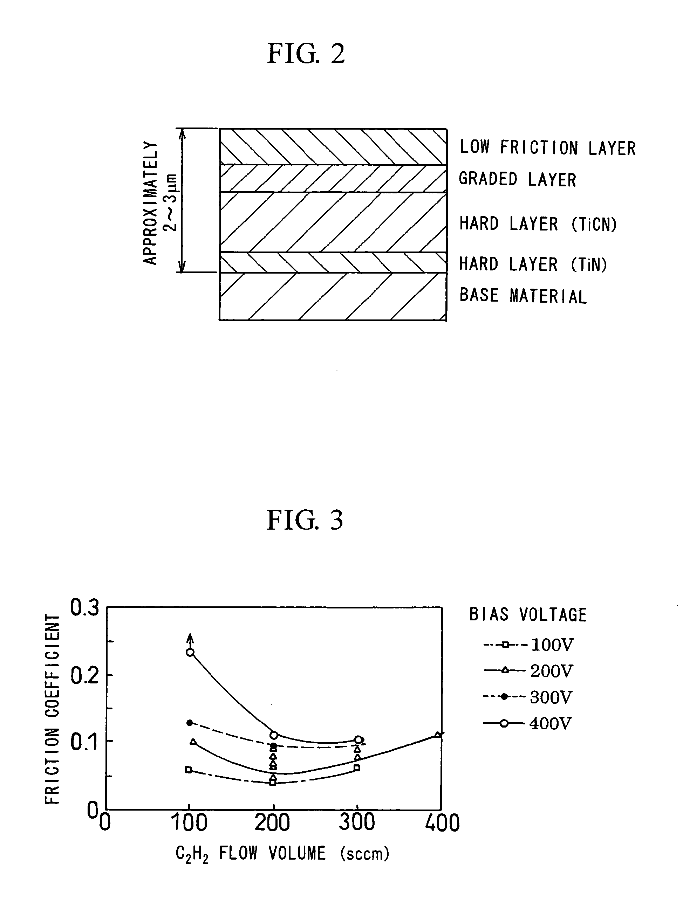

Fig. 2 shows a cross-sectional view of an example of a slide member having a metal composite diamond-like carbon (DLC) film of the invention. In addition to the metal composite diamond-like carbon (DLC) film of the invention used in a low-friction layer, the member comprises a hard layer comprising metal nitride (TiN), another hard layer comprising metal carbonitride (TiCN), and a metal-carbon composition graded layer formed on the hard layers. In the case of the slide member in Fig.2, there are two hard layers comprising metal nitride.

In the slide member of Fig. 2, by adding the hard layer (TiCN), as hardness of the film is further improved, wear resistance thereof is also improved. Further, even if the low-friction layer and the graded layer are worn out due to wear or the like, there is little possibility of rapid seizure or the like, since friction characteristics of TiCN are superior to those of TiN. While the same concept can be applied to Ta, Cr, or the like, instead of Ti, Ti is the most effective in terms of material cost.

### [Example]

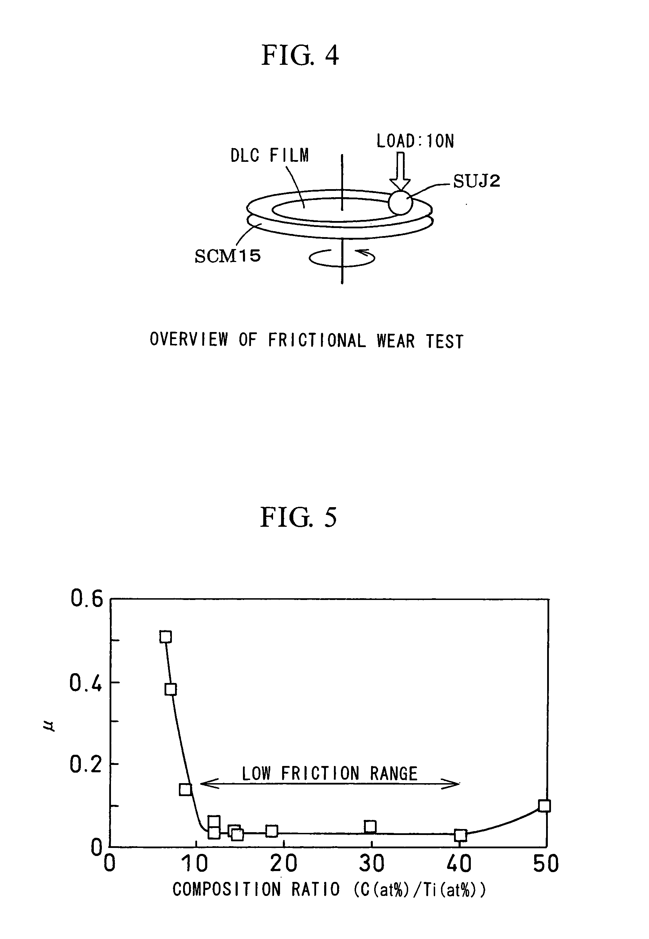

The feasibility of forming a metal composite DLC film was examined by adding hydrocarbon gas during arc discharge. As a material, a Ti material that is low in cost and friction coefficient was used, and acetylene was used as a gas. First, the film was formed by fixing the output of arc discharge and changing the flow volume of acetylene and a bias voltage. Next, the friction coefficient was examined. Fig. 3 shows the results. The friction coefficient was evaluated based on the frictional wear test (ball-on-disk) shown in Fig. 4.

Fig. 4 shows a schematic diagram of the ball-on-disk test. A disk including the metal composite DLC film formed on an SCM 15 carburized material as a base material was pressed by an iron ball of SUJ2 with a load of 10 N. The test was carried out under the following conditions: a contact Hertzian stress of 1300 MPa; a rate of 0.3 m/s; a distance of 2 km; and a dry, non-lubricated state.

The results in Fig. 3 show that, in the AIP process, there exist optimum values of the flow volume of acetylene and the bias voltage, and that the friction coefficient was as low as 0.05. Fig. 5 shows the results in which the relationship between the carbon-to-metal ratio of the film and the friction coefficient is organized. Based on the results in Fig. 5, it is confirmed that there exist an optimum range of the carbon-to-metal ratio with regard to the metal composite DLC film formed by the AIP process of the invention, too. As the results in Fig. 5 show, a region of low friction is wider, and thus it can be said that the film has robustness with respect to performance.

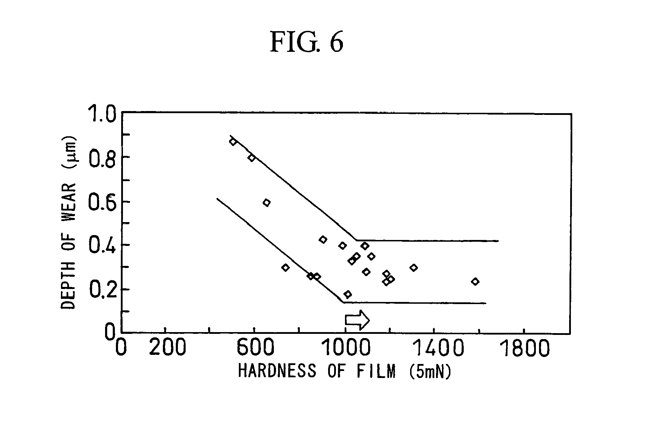

Fig. 6 shows the relationship between the hardness of the film and the depth of wear. With regard to wear resistance of the film, the quantity of wear of the film based on the frictional wear test shown in Fig. 4 was organized with hardness of the film by changing the coating conditions. When the friction coefficient was limited to 0.2 or below, as the results in Fig. 6 show, the depth of wear was reduced as the hardness of the film was increased, and the depth of wear tended to be saturated at about 1000 or above. While it is effective to densify the film by increasing the bias voltage in order to increase the hardness of the film, it has been found that both a low friction coefficient and superior wear resistance are achieved since hardness 1000 or more at 200 V that shows low friction shown in Fig. 3 is obtained.

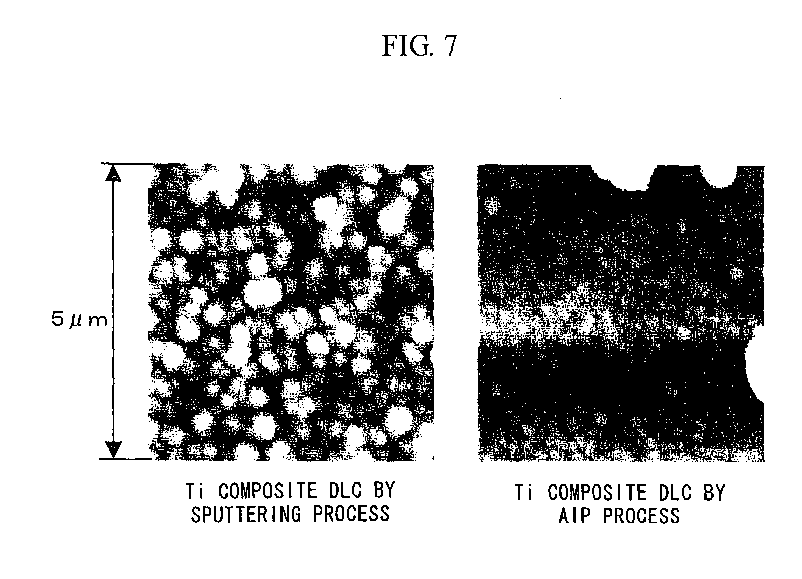

For examining the cause, the results of an analysis, using an atomic force microscope (AFM), on a film surface form of a Ti composite DLC film formed by a sputtering process and that of a Ti composite DLC film formed by the AIP process of the present invention are shown in Fig. 7. As the results in Fig. 7 show, it was observed that the particles of the Ti composite DLC film formed by the AIP process were denser than those of the Ti composite DLC film formed by the sputtering process even when the same bias voltage, 200 V, was applied.

### [DLC film having a graded layer]

For the purpose of improving adhesion of the film, there were provided, as intermediate layers, a hard film, for the manufacture of which the AIP process is suitably used, and a composition graded layer in contact with a DLC layer that is the uppermost surface layer. In a conventional DLC film, while a metal layer (soft) is disposed directly on a base material, it was found that peeling occurs at the metal layer because of the low strength of this portion. So, the strength thereof was increased by providing a hard layer (TiN, TiC, TiCN, or the like) directly on the base material. Adhesion was ensured by providing a graded layer that reduces stress of the film between the hard layer and the uppermost surface low friction layer, the graded layer being formed by inclining a bias voltage and a hydrocarbon gas.

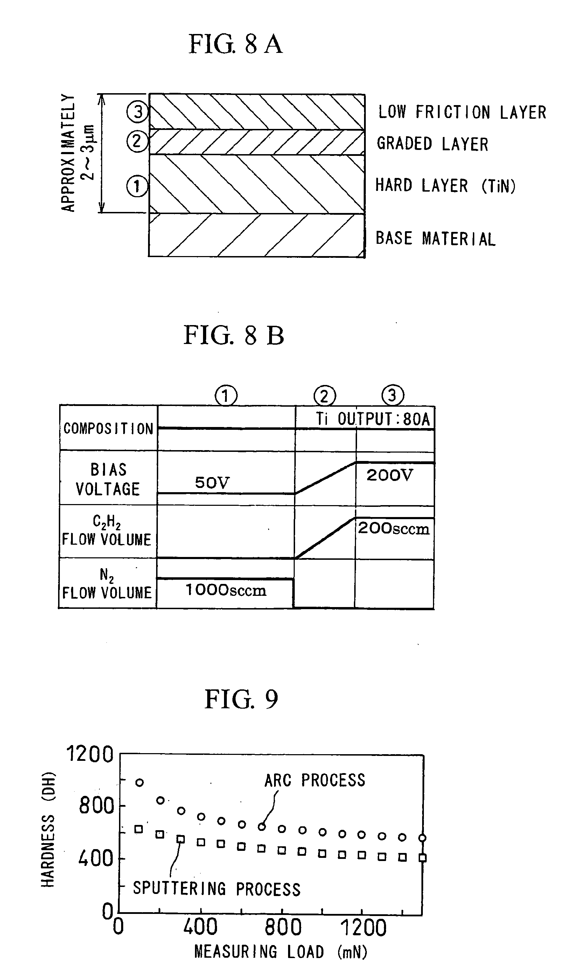

Fig. 8(a) shows a cross-sectional view of a slide member comprising a DLC film having the graded layer of the invention. Fig. 8(b) shows an example of coating conditions when forming the film. A hard film (TiN) was formed by subjecting Ti to the AIP process in a nitrogen gas flow. Next, a graded layer was formed by subjecting Ti to the AIP process as the flow of acetylene was increased. Finally, a low friction layer was formed by subjecting Ti to the AIP process in a certain volume of acetylene flow.

The adhesion of the DLC film thus obtained was evaluated by a scratch test, and the results showed that an adhesion of 30 to 50 N was obtained in accordance with the invention while that of a conventional film was 15 to 30 N. This may be attributable to increased resistance to peeling, because, in the AIP process, prior to the film formation, the base material was bombarded with metal ions for surface activation, the interfacial adhesion to the base material was enhanced due to the effect of ion implantation or the like, and a hard layer was made to have a columnar crystal structure with the same density (high strength).

The arrangement of the hard layer also contributes to increase in hardness when the film is pressed from above. Namely, since the hard layer has the function of suppressing elastic deformation by backing up a load, it is presumed that it also contributes to improvement in wear resistance. Fig. 9 shows comparison of hardness characteristics between a member of which hard layer was formed by the AIP process and a member of which hard layer was formed by a sputtering process.

As the results in Fig. 9 show, it can be seen that the invention achieves a lower friction, a higher adhesion, and a higher wear resistance than those of the conventional technologies.

### [Removal of macro-particles (droplets)]

In the invention, it is preferable that there is provided a step for removing projections generated on a surface during film formation. One of the characteristics of the AIP process is the problem that macro-particles (droplets) are generated during coating, and it has been proposed to take measures in terms of equipment or to provide a barrier in front of a work, for example. However, such measures diminish the process merit of forming a film with high efficiency. For such reason, in the invention, droplets were removed after film formation and it was confirmed that the foregoing film performance was ensured.

For removing such droplets, water jet, sand paper (about #500), paper lap, and aero lap are effective, for example. In the case of oil lubrication, concave portions after removal of droplets act as oil reservoirs, and thus they effectively function in the case of oil shortage or the like. Further, even when a defective film adhesion or the like is generated due to defective washing or the like, the step for removing droplets (physical process to the film) makes peeling obvious, thereby preventing the outflow of defective products.

In accordance with the invention, a slide member comprising a diamond-like carbon layer that has a low friction coefficient and that is superior in wear resistance and adhesion can be obtained. The diamond-like carbon can be used as a slide member in various types of fields. Particularly, the invention can provide a DLC film with low friction by forming a composite layer of an appropriate ratio by introducing hydrocarbon gas (acetylene or the like) when a metal such as Ti is discharged using the AIP process. In addition, the DLC film having both adhesion and wear resistance can be provided by arranging a hard layer (TiCN, TiN, or the like) as an intermediate layer. Furthermore, even if normal droplets are generated, performance can be ensured by removing them via aero lap or the like, and defective products can be determined.

## Claims

1. A metal composite diamond-like carbon (DLC) film formed on a base material which is obtainable by a method which comprises sublimating a metal target using arc discharge, introducing a hydrocarbon gas and ionizing the metal and hydrocarbon.

2. A metal composite diamond-like carbon (DLC) film according to claim 1 wherein the metal target is sublimated alone and wherein a solid carbon target is not used.

3. A metal composite diamond-like carbon (DLC) film according to either claim 1 or claim 2, wherein the metal element is at least one selected from the group consisting of the IV-A, V-A, VI-A, and III-B groups and Si.

4. A metal composite diamond-like carbon (DLC) film according to any one of claims 1 to 3 wherein the atomic ratio of carbon/metal elements in the diamond-like carbon (DLC) film formed on the base material is 10 to 70.

5. A metal composite diamond-like carbon (DLC) film according to any one of claims 1 to 4, wherein the friction coefficient is 0.1 or below.

6. A metal composite diamond-like carbon (DLC) film according to any one of claims 1 to 5, wherein the friction coefficient is 0.05 or below.

7. A method for forming a metal composite diamond-like carbon (DLC) film wherein the metal composite diamond-like carbon (DLC) film is formed on a base material which method comprises disposing a metal target as a cathode in a vacuum chamber, introducing a hydrocarbon gas into the vacuum chamber, sublimating the metal target using arc discharge and ionizing the metal and hydrocarbon.

8. A method for forming a metal composite diamond-like carbon (DLC) film according to claim 7, wherein the hydrocarbon gas is at least one of chain hydrocarbon compounds selected from the group consisting of alkane, alkene, and alkyne compounds.

9. A method for forming a metal composite diamond-like carbon (DLC) film according to claim 8, wherein the hydrocarbon gas is at least one selected from the group consisting of methane, ethylene, and acetylene.

10. A method for forming a metal composite diamond-like carbon (DLC) film, wherein after forming a metal composite diamond-like carbon (DLC) film by a method according to any one of claims 7 to 9, generated macro-particles (droplets) are removed.

11. A method for forming a metal composite diamond-like carbon (DLC) film according to claim 10, wherein the method for removing macro-particles (droplets) is at least one selected from the group consisting of water jet, sand paper, paper lap, and aero lap.

12. An apparatus for forming a diamond-like carbon (DLC) film, the apparatus comprising:
an arc power supply;
a bias power supply for applying a negative bias to a base material in a vacuum chamber in which the diamond-like carbon (DLC) film is formed; and
an opening for introducing hydrocarbon gas and inert gas,
wherein the arc power supply is provided to a metal target and
wherein the diamond-like carbon (DLC) film is formed on a base material by sublimating the metal target using arc discharge under an atmosphere which comprises a hydrocarbon gas and ionizing the metal and hydrocarbon.

13. An apparatus for forming a metal composite diamond-like carbon (DLC) film according to claim 12, wherein the metal element of the metal target is at least one selected from the group consisting of the IV-A, V-A, VI-A and III-B group elements and Si.

14. A slide member comprising:
a base material; and
a protective film formed on a surface of the base material,
wherein the protective film comprises the metal composite diamond-like carbon (DLC) film according to any one of claims 1 to 6.

15. A slide member comprising a base material and a protective film formed on a surface of the base material,
wherein the protective film comprises (a) a hard layer comprising metal nitride or metal carbonitride, (b) a metal-carbon composition graded layer formed on the hard layer, and (c) the metal composite diamond-like carbon (DLC) film according to any one of claims 1 to 6 formed on the metal carbon composition graded layer.

16. A slide member comprising a base material and a protective film formed on a surface of the base material,
wherein the protective film comprises (a) a hard layer comprising metal nitride or metal carbonitride, (b) a metal-carbon composition graded layer formed on the hard layer, and (d) an alternately laminated layer of the metal composite diamond-like carbon (DLC) film according to any one of claims 1 to 6 formed on the metal-carbon composition graded layer and a metal-carbon hard layer obtained by reducing the amount of hydrocarbon gas added.

17. A slide member according to claim 15 or 16, wherein (a) the hard layer comprising metal nitride or metal carbonitride comprises two or more layers.

18. A slide member according to any one of claims 14 to 17, wherein the friction coefficient is 0.1 or below.

19. A slide member according to any one of claims 14 to 18, wherein the friction coefficient is 0.05 or below.

20. A slide member according to any one of claims 14 to 19, wherein the dynamic hardness of the film hardness is 1000 to 3000 when a measuring load is 5 mN.
